Europäisches Patentamt

European Patent Office

Office européen des brevets

(19)

(11) Numéro de publication : **0 052 544**
**B1**

(12) FASCICULE DE BREVET EUROPÉEN

(45) Date de publication du fascicule du brevet :
26.09.84

(51) Int. Cl.³ : **H 03 G   5/00**, **H 03 G   9/00**

(21) Numéro de dépôt : **81401685.3**

(22) Date de dépôt : **23.10.81**

(54) Circuit de commande de tonalité.

(30) Priorité : **14.11.80 FR 8024231**

(43) Date de publication de la demande :
**26.05.82 Bulletin 82/21**

(45) Mention de la délivrance du brevet :
**26.09.84 Bulletin 84/39**

(84) Etats contractants désignés :
**DE FR GB IT NL**

(56) Documents cités :
**DE-A- 2 625 922**
**GB-A- 1 304 774**
**US-A- 4 045 748**

(73) Titulaire : **THOMSON-CSF**
**173, Boulevard Haussmann**
**F-75379 Paris Cedex 08 (FR)**

(72) Inventeur : **Blachot, Denis**
**THOMSON-CSF SCPI 173, bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

## Description

La présente invention concerne un circuit de commande de tonalité et plus particulièrement un tel circuit adapté au réglage de la tonalité d'un signal à fréquence sonore, notamment un signal musical, dans un diffuseur de signaux sonores tel qu'un récepteur de radio, un téléviseur, un appareil à disque gravé, ou un appareil de diffusion d'enregistrement magnétique.

Dans ces divers appareils, il est couramment prévu que l'utilisateur peut effectuer une sélection de l'intensité sonore dans diverses plages de la bande de fréquence pour favoriser par exemple les graves (basse fréquence) ou les aigus (haute fréquence). Ce réglage est destiné à adapter la diffusion sonore aux goûts musicaux particuliers de l'utilisateur et/ou à corriger les défauts existants dans l'information sonore enregistrée ou transmise.

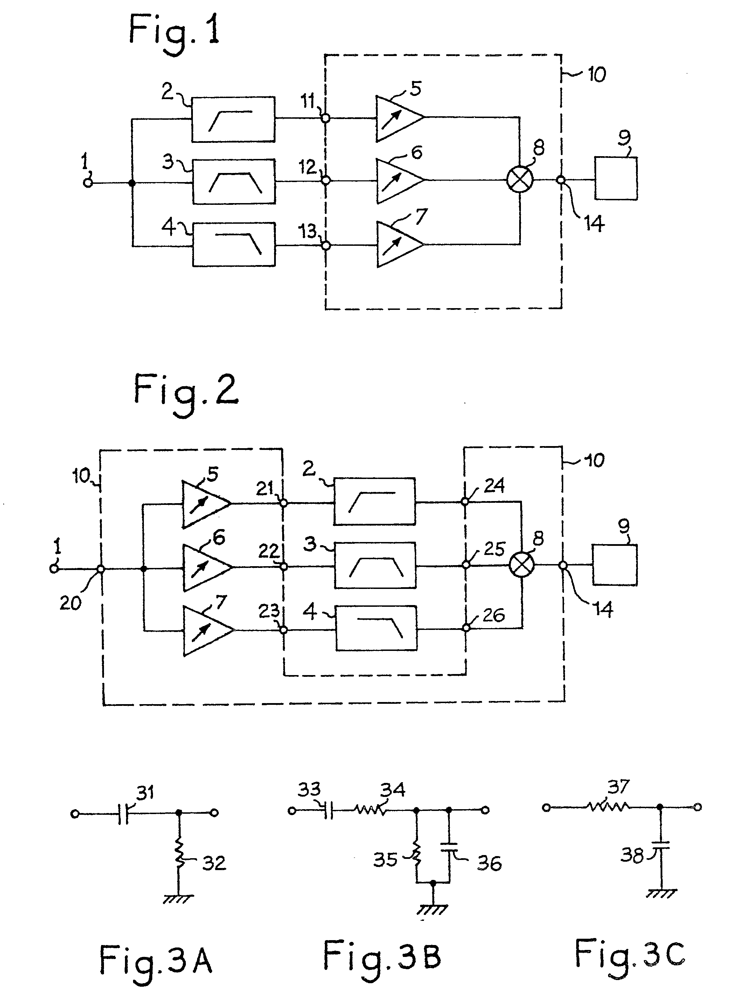

Parmi les nombreuses structures de circuit permettant d'atteindre ce résultat, on retrouve actuellement fréquemment des structures de circuit du type de celle presentée en figure 1, dans laquelle un signal sonore arrivant sur une entrée 1 est transmise à trois filtres 2, 3 et 4, respectivement un filtre passe-haut, un filtre passe-bande et un filtre passe-bas. Ces filtres sont disposés en parallèle et leur action est plus ou moins importante sur le signal incident en fonction du réglage de potentiomètres électroniques 5, 6 et 7 en série avec chacun de ces filtres. Les signaux de sortie des potentiomètres électroniques sont transmis par l'intermédiaire d'un circuit mélangeur 8 à d'autres circuits 9 nécessaires à la mise en forme et à l'amplification convenable des signaux électriques pour leur transformation sous forme sonore par un transducteur tel qu'un haut parleur.

On vise actuellement à insérer le plus grand nombre de composants électroniques d'un ensemble donné sur une même pastille sous forme de circuit intégré. Cela n'est généralement pas possible pour des éléments de filtre qui comprennent des condensateurs et des résistances de valeur bien déterminée. Ainsi, dans un circuit tel que celui de la figure 1, les filtres 2, 3 et 4 seraient disposés à l'extérieur du circuit intégré renfermant les éléments entourés du cadre en pointillés 10 et il conviendrait de prévoir trois bornes 11, 12 et 13 d'accès aux entrées des potentiomètres électroniques et une borne de sortie 14.

Comme cela est bien connu, il serait avantageux pour obtenir une réduction du bruit de disposer les divers filtres de chacune des voies après le potentiomètre électronique de la voie correspondante et non avant, afin d'éliminer le bruit produit par ce potentiomètre électronique dans la bande rejetée par le filtre. Cette disposition est couramment appliquée dans les circuits réalisés sous forme d'éléments discrets mais pas dans les circuits réalisés sous forme de circuit intégré. En effet, comme le représente la figure 2 dans laquelle de mêmes éléments sont désignés par de mêmes références qu'en figure 1, il conviendrait alors, au lieu de prévoir quatre bornes d'accès 11, 12, 13 et 14 au circuit intégré 10, de prévoir huit bornes d'accès, à savoir une borne d'entrée 20, trois bornes de sortie 21, 22 et 23 pour chacun des potentiomètres électroniques, et trois bornes d'entrée 24, 25 et 26 vers un mélangeur ou additionneur 8 et une borne de sortie 14 pour cet additionneur.

Or il s'avère que l'une des causes de coût les plus importantes d'un circuit intégré réside dans le nombre de ses bornes d'accès, c'est-à-dire dans son nombre de pattes de connexion. C'est là aussi l'une des sources de défauts les plus importantes des circuits intégrés. Il est donc prohibitif pour obtenir une amélioration du rapport signal sur bruit d'envisager de prévoir quatre bornes d'accès supplémentaires au circuit intégré.

Les figures 3A, 3B et 3C représentent à titre d'exemple des filtres passifs particulièrement simples pouvant servir respectivement de filtre passe-haut, passe-bande, et passe-bas. Le filtre passe-haut de la figure 3A comprend un élément série constitué d'un condensateur 31 et un élément parallèle constitué d'une résistance 32. Le filtre passe-bande de la figure 3B comprend un élément série constitué d'un condensateur 33 et d'une résistance 34 en série, et un élément parallèle constitué d'une résistance 35 et d'un condensateur 36 en parallèle. Le filtre passe-bas de la figure 3C comprend un élément série constitué d'une résistance 37 et un élément parallèle constitué d'un condensateur 38. Ainsi, l'ensemble de filtres le plus simple correspondant aux trois filtres 2, 3 et 4 de la figure 2 comprend huit composants discrets à savoir quatre condensateurs et quatre résistances. Un tel nombre de composants discrets occupera une place très importante, en pratique plus importante que le circuit intégré comprenant les divers amplificateurs 5, 6 et 7.

Ainsi, un objet de la présente invention est de prévoir un circuit de filtrage de tonalité du type décrit précédemment mais permettant de minimiser le nombre de bornes d'accès au circuit intégré comprenant les potentiomètres électroniques.

Un autre objet de la présente invention est de prévoir un tel circuit de commande de tonalité dans lequel le nombre d'éléments discrets de chacun des filtres soit réduit par rapport aux dispositifs classiques.

Pour atteindre ces objets ainsi que d'autres, la présente invention prévoit un circuit de commande de tonalité comprenant, entre une borne d'entrée et une borne de sortie reliée à un circuit à forte impédance d'entrée, plusieurs voies en parallèle dont chacune comporte un potentiomètre électronique à faible impédance de sortie et comprenant en outre des filtres passifs dont chacun comporte un élément série et un élément parallèle, ce circuit, à l'exclusion des éléments de filtrage, étant réalisé sous forme de circuit intégré. Chacun des éléments série est disposé entre la sortie de chaque potentiomètre électronique et ladite borne de sortie, d'où il résulte que chaque filtre est constitué de l'élément série d'une voie donnée et d'un élément parallèle constitué de l'association en parallèle des éléments série des autres voies. Dans le cas où le circuit ne comprend que deux voies de filtrage, l'une de filtrage passe-bas et l'autre de filtrage passe-haut, l'élément série de la première voie peut être une résistance et l'élément série de la seconde voie un condensateur. Si le circuit comprend une troisième voie de filtrage passe-bande, l'élément série de cette troisième voie peut être constitué d'une résistance et d'un condensateur disposés en série. En outre, pour améliorer les caractéristiques de filtrage, un condensateur intermédiaire peut être relié entre la sortie du potentiomètre électronique de la troisième voie et un point intermédiaire de la résistance de la première voie. De façon plus générale, il est possible de prévoir des éléments intermédiaires connectés entre une voie et une autre, pour améliorer les caractéristiques de filtrage, étant entendu qu'il n'est pas prévu de liaison à la masse entre les bornes de sortie des potentiomètres et le point de connexion des éléments série.

Les modes de réglage des divers potentiomètres électroniques ne seront pas décrits en détail étant donné que les divers systèmes existants peuvent être utilisés. On pourra notamment utiliser le procédé de réglage indépendant de tonalité et d'intensité sonore tel qu'il a été décrit dans la demande de brevet n° 79/22885 déposée par la demanderesse le 13 septembre 1979.

Ces objets, caractéristiques et avantages ainsi que d'autres de la présente invention seront décrits plus en détail dans la description suivante de modes de réalisations particuliers faite en relation avec les figures jointes parmi lesquelles :

la figure 1 représente un circuit de réglage de tonalité de l'art antérieur qui a été décrit ci-dessus ;

la figure 2 représente une variante possible du circuit de tonalité de l'art antérieur qui a également été décrite ci-dessus ;

les figures 3A, 3B et 3C représentent des modes de réalisations possibles de filtres utilisables dans les circuits de réglage de tonalité de l'art antérieur ; ces figures ont également été décrites ci-dessus ;

la figure 4 représente un mode de réalisation de circuit de réglage de tonalité selon la présente invention ;

les figures 5A, 5B et 5C représentent des filtres équivalents aux filtres obtenus dans le mode de réalisation de la figure 4 ;

la figure 6 représente une variante d'agencement d'éléments de filtrage par rapport à celle de la figure 4 ; et

les figures 7A, 7B et 7C représentent les schémas équivalents des filtres obtenus par le circuit de la figure 6.

Dans les diverses figures, de mêmes références désignent des éléments ou des bornes de connexion analogues.

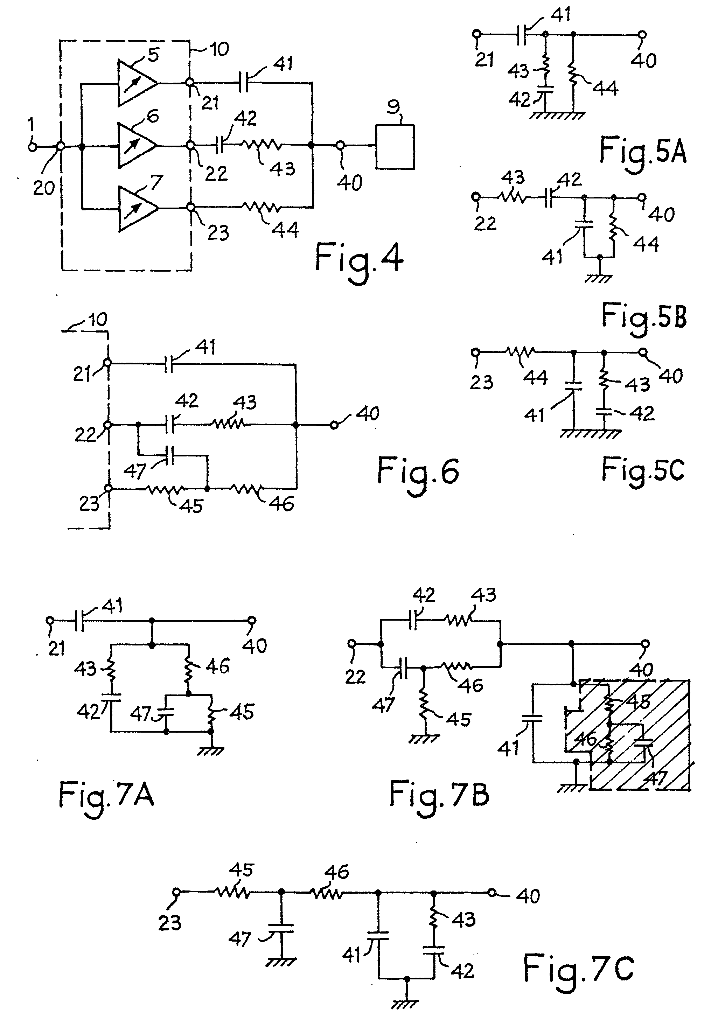

Le circuit selon l'invention représenté en figure 4 diffère du circuit représenté en figure 2 essentiellement par le fait que ce ne sont pas des filtres complets comprenant des bornes de connexion à la masse, mais seulement des éléments de filtre ne comprenant pas de bornes de connexion à la masse qui sont connectées entre la sortie de chacun des potentiomètres électroniques et une borne de connexion commune 40 et non pas à diverses entrées d'un mélangeur. Ainsi, en se plaçant dans le cas où l'ensemble des circuits 9 présente une entrée à haute impédance et où chacun des potentiomètres électroniques 5, 6 et 7 présente une sortie de faible impédance, on peut considérer, conformément au modèle mathématique dit théorème de superposition, que chacune des sorties 5, 6 et 7 est connectée à la borne 40 par l'intermédiaire d'un filtre dont l'élément série est constitué par l'élément connecté entre cette sortie et la borne 40 et dont l'élément parallèle, fictivement relié à la masse, est constitué par l'association en parallèle des éléments disposés entre la sortie des autres potentiomètres électroniques et la borne commune 40. Cet agencement permet, comme le montre le mode de réalisation particulier de la figure 4, d'obtenir des filtres en utilisant un nombre de composants extrêmement réduit. Dans le cas représenté en figure 4, l'élément série de la première voie est constitué d'un condensateur 41, l'élément série de la seconde voie d'un condensateur 42 en série avec une résistance 43, et l'élément série de la troisième voie d'une résistance 44. Ainsi, les filtres équivalents à la sortie des première, seconde et troisième voie sont tels que représentés en figure 5A, 5B et 5C. On notera que le nombre total de bornes d'accès au circuit intégré 10 est de quatre comme dans le cas de la figure 1 et non pas de huit comme dans le cas de la figure 2.

Un autre avantage du circuit de la figure 4 par rapport aux circuits de l'art antérieur réside dans le fait que, si les trois potentiomètres électroniques 5, 6 et 7 sont réglés au même gain, on obtient à la borne 40 un signal proportionnel au signal à la borne d'entrée 20 sans aucun effet de filtrage étant donné qu'il n'existe pas de connexion à la masse entre les bornes 21, 22 et 23 d'une part et la borne 40 d'autre part. Cette tonalité plate est pratiquement impossible à obtenir en prévoyant trois ensembles de filtres tels que les filtres 2, 3, 4 des figures 1 et 2, que ces filtres soient disposés avant ou après les potentiomètres électroniques. On notera d'ailleurs qu'on a été souvent amené dans l'art antérieur pour éviter cette difficulté à prévoir une voie supplémentaire ne comprenant aucun élément de filtrage, ce qui complique ces circuits de l'art antérieur plus encore que cela n'a été représenté et exposé précédemment.

La figure 6 montre comment, en ajoutant un seul composant supplémentaire, en l'occurrence un condensateur 47, entre la borne 22 et un point intermédiaire de la résistance 44 figurée sous forme de deux résistances série 45 et 46, on peut obtenir un autre type de filtre ayant une fonction de filtrage beaucoup plus complexe comme le représentent les schémas équivalents des figures 7A, 7B et 7C.

De façon générale, le procédé selon la présente invention reste valable si d'autres éléments de filtrage sont rajoutés de façon appropriée du moment qu'il n'est pas prévu de connexion à la masse intermédiaire entre chacune des bornes 21, 22, 23 et la borne 40.

On a décrit ci-dessus à titre d'exemple le cas, où trois voies de filtrage était prévu. Bien entendu, dans la pratique on pourra prévoir des circuits de réglage de tonalité comprenant seulement deux voies de réglage ou au contraire un nombre de voies plus important.

La présente invention n'est pas limitée aux modes de réalisations qui ont été explicitement décrits ; elle en englobe les variantes et généralisations incluses dans le domaine des revendications ci-après.

## Revendications

1. Circuit de commande de tonalité comprenant, entre une borne d'entrée (1) et une borne de sortie (40) reliée à un circuit (9) à forte impédance d'entrée, plusieurs voies en parallèle dont chacune comporte un potentiomètre électronique (5, resp. 6, 7) à faible impédance de sortie et comprenant en outre des filtres passifs dont chacun comporte un élément série et un élément parallèle, ce circuit, à l'exclusion des éléments de filtrage, étant réalisé sous forme de circuit intégré, caractérisé en ce que chacun des éléments série (41, resp. 42-43, 44) est disposé entre la sortie (21, resp. 22, 23) de chaque potentiomètre électronique et ladite borne de sortie, d'où il résulte que chaque filtre est constitué de l'élément série d'une voie donnée et d'un élément parallèle constitué de l'association en parallèle des éléments série des autres voies.

2. Circuit selon la revendication 1 comprenant deux voies, l'une de filtrage passe-bas, l'autre de filtrage passe-haut, caractérisé en ce que dans la première voie l'élément série est une résistance (44) et dans la seconde voie l'élément est un condensateur (41).

3. Circuit selon la revendication 2 comprenant en outre une troisième voie de filtrage passe-bande, caractérisé en ce que, dans cette troisième voie, l'élément série comprend l'association en série d'une résistance (43) et d'un condensateur (42).

4. Circuit selon la revendication 3, caractérisé en ce qu'il comprend en outre un condensateur (47) disposé entre la sortie (22) du potentiomètre électronique de la seconde voie et un point intermédiaire de la résistance (45, 46) de la première voie.

5. Circuit selon la revendication 1, caractérisé en ce qu'il comprend au moins un élément intermédiaire entre un point de connexion disposé sur le trajet série à la sortie du potentiomètre électronique d'une voie et le trajet série à la sortie du potentiomètre électronique d'une autre voie.

6. Circuit selon la revendication 1, caractérisé en ce qu'il comprend des moyens de réglage d'intensité sonore à tonalité constante et des moyens de réglage de tonalité à intensité sonore constante.

## Claims

1. Tone control circuit comprising, between an input terminal (1) and an output terminal (40) connected to a circuit (9) having a high input impedance, a plurality of parallel paths each of which comprises an electronic potentiometer (5, 6, 7, respectively) having a low output impedance, and further comprising passive filters each of which comprises a serial member and a parallel member, this circuit being embodied as an integrated circuit with the exception of the filter members, characterized in that each of the serial members (41, 42-43, 44, respectively) is disposed between the output (21, 22, 23, respectively) of each electronic potentiometer and said output terminal, resulting in that each filter is formed of the serial member of a given path and a parallel member formed of the parallel association of the serial members of the other paths.

2. Circuit according to claim 1 and comprising two paths, one being a low pass filter and the other a high pass filter, characterized in that the serial member of the first path is a resistor (44) and the serial member of the second path is a capacitor (41).

3. Circuit according to claim 1 and further comprising a third, band pass filter path, characterized in that the serial member of this third path comprises the series connection of a resistor (43) and a capacitor (42).

4. Circuit according to claim 3, characterized in that it further. comprises a capacitor (47) disposed between the output (22) of the electronic potentiometer of the second path and an intermediate point of the resistor (45, 46) of the first path.

5. Circuit according to claim 1, characterized in that it comprises at least one intermediate member between a connection point disposed on the serial path at the output of the electronic potentiometer of one path and the serial path at the output of the electronic potentiometer of another path.

6. Circuit according to claim 1, characterized in that it comprises means for constant tone volume adjustment and means for constant volume tone control.

## Ansprüche

1. Klangregelschaltung, die zwischen einem Eingangsanschluß (1) und einem Ausgangsanschluß (40), der an eine Schaltung (9) mit hoher Eingangsimpedanz angeschlossen ist, mehrere parallel liegende Zweige enthält, von denen jeder ein elektronisches Potentiometer (5 bzw. 6 bzw. 7) mit niedriger Ausgangsimpedanz umfaßt, und ferner passive Filter enthält, die jeweils ein Serienelement und ein Parallelelement umfassen, wobei diese Schaltung mit Ausnahme der Filterelemente als integrierte Schaltung ausgebildet ist, dadurch gekennzeichnet, daß jedes der Serienelemente (41 bzw. 42-43, 44) jeweils zwischen dem Ausgang (21 bzw. 22, 23) eines elektronischen Potentiometers und dem Ausgangsanschluß angeordnet ist, wodurch sich ergibt, daß jedes Filter aus dem Serienelement eines gegebenen Zweiges und einem Parallelelement gebildet ist welches durch die Parallelschaltung der Serienelemente der anderen Zweige gebildet ist.

2. Schaltung nach Anspruch 1, die zwei Zweige enthält, von denen der eine ein Tiefpaßfilter und der andere ein Hochpaßfilter ist, dadurch gekennzeichnet, daß das Serienelement des ersten Zweiges ein Widerstand (44) und das Serienelement des zweiten Zweiges ein Kondensator (42) ist.

3. Schaltung nach Anspruch 2, die ferner einen dritten Zweig als Bandpaßfilter enthält, dadurch gekennzeichnet, daß das Serienelement des dritten Zweiges eine Reihenschlatung aus einem Widerstand (43) und einem Kondensator (42) enthält.

4. Schaltung nach Anspruch 3, dadurch gekennzeichnet, daß sie ferner einen Kondensator (47) enthält, der zwischen dem Ausgang (22) des elektronischen Potentiometers des zweiten Zweiges und einem Abgriff des Widerstandes (45, 46) des ersten Zweiges angeordnet ist.

5. Schaltung nach Anspruch 1, dadurch gekennzeichnet, daß sie wenigstens ein Zwischenelement zwischen einem Verbindungspunkt, der auf dem Serienweg am Ausgang des elektronischen Potentiometers eines Zweiges liegt, und dem Serienweg am Ausgang des elektronischen Potentiometers eines anderen Zweiges enthält.

6. Schaltung nach Anspruch 1, dadurch gekennzeichnet, daß sie Mittel zur Lautstärkeeinstellung bei konstantem Klang und Mittel zur Klangregelung bei konstanter Lautstärke enthält.

# Fig.1

# Fig.2

## Fig.3A

## Fig.3B

## Fig.3C

Fig.4

Fig.5A

Fig.5B

Fig.6

Fig.5C

Fig.7A

Fig.7B

Fig.7C

2